# EUROPÄISCHE PATENTSCHRIFT

(11) **EP 2 126 645 B1**
(45) Veröffentlichungstag und Bekanntmachung des Hinweises auf die Patenterteilung: **04.07.2012**
(21) Anmeldenummer: 06841604.9
(22) Anmeldetag: 22.12.2006
(51) Int. Cl.: G05B 19/401

(54) **VERFAHREN ZUM KALIBRIEREN DER X-Y POSITIONIERUNG EINES POSITIONIERWERKZEUGS, SOWIE VORRICHTUNG MIT EINEM DERARTIGEN POSITIONIERWERKZEUG**
METHOD FOR CALIBRATING THE X-Y POSITIONING OF A POSITIONING TOOL, AND APPARATUS WITH SUCH A POSITIONING TOOL
PROCÉDÉ DE CALIBRAGE DU POSITIONNEMENT X-Y D'UN OUTIL DE POSITIONNEMENT ET DISPOSITIF ÉQUIPÉ D'UN TEL OUTIL DE POSITIONNEMENT

(43) Veröffentlichungstag der Anmeldung: 02.12.2009
(73) Patentinhaber: Kulicke & Soffa Die Bonding GmbH, 8572 Berg TG (CH)
(72) Erfinder: MARTE, Andreas, CH-8280 Kreuzlingen (CH); ERNST, Urban, 78464 Konstanz (DE); SCHUSTER, Johannes, 78462 Konstanz (DE)
(86) Internationale Anmeldenummer: PCT/EP2006/070182
(87) Internationale Veröffentlichungsnummer: WO 2008/083701

(56) Entgegenhaltungen:
- EP-A- 1 395 106
- EP-A- 1 437 933
- US-B1- 6 648 730
- US-B1- 6 876 761
- ZHENG J Y ET AL: "USE OF AN ACTIVE CAMERA FOR EYE-HAND COORDINATION IN ROBOT MANIPULATION" 1. November 1994 (1994-11-01), SYSTEMS & COMPUTERS IN JAPAN, WILEY, HOBOKEN, NJ, US, PAGE(S) 73-86 , XP000526364 ISSN: 0882-1666 Seite 76, Spalte 1, Zeile 1 - Seite 77, Spalte 2, Zeile 6 Seite 82, Spalte 2, Zeile 3 - Seite 83, Spalte 1, Zeile 10 Seite 84, Spalte 1, Zeile 1 - Seite 84, Spalte 2, Zeile 20
- ANONYMOUS: "AdeptVision User's Guide - Version 13.0" [Online] 31. Juli 1998 (1998-07-31), ADEPT TECHNOLOGY INC , SAN JOSE, CA, USA , XP002452343 Gefunden im Internet: URL:http://www.adept.com/main/KE/DATA/ARCH IVED/SUMMER00/ENGLISH/V_VMEUG.PDF> [gefunden am 2007-09-25] Seite 1 - Seite 3 Seite 35 - Seite 39 Seite 65 - Seite 116

## Beschreibung

Die Erfindung betrifft ein Verfahren zum Kalibrieren der x-y Positionierung eines Positionierwerkzeuges gemäss dem Oberbegriff von Anspruch 1, ein Verfahren zum Kalibrieren eines Bilderkennungssystem basierten Positioniersystems gemäss dem Oberbegriff von Anspruch 6, ein Verfahren zum Platzieren eines Bauteils aus einem Substrat gemäss dem Oberbegriff von Anspruch 7, ein Verfahren zum Rekalibrieren gemäss dem Oberbegriff von Anspruch 11,

und eine Kalibriervorrichtung zum Kalibrieren der x-y Positionierung eines Bilderkennungssystem basierten Positionierwerkzeuges gemäss dem Oberbegriff von Anspruch 12.

Derartige Verfahren und Vorrichtungen können insbesondere im Zusammenhang mit so genannten "Pick und Place" - Werkzeugen zum Handhaben von Halbleiterbauelementen eingesetzt werden. Dabei werden Halbleiterbauelemente, insbesondere Halbleiterchips auf entsprechende Substrate, die sich in einer Arbeitsfläche befinden, abgelegt bzw. gebondet.

Die exakte Position und Ausrichtung der Bauteile beim Absetzen und des Werkzeugs beim Annähern an die Arbeitsfläche spielen dabei eine bedeutende Rolle, sodass spezielle Massnahmen für die Positionierung des Positionier- bzw. Aufnahmewerkzeugs erforderlich sind.

Ein Positioniersystem umfasst zumeist ein Positionierwerkzeug, insbesondere ein "Pick und Place" - Werkzeug, das in der Regel über mehrere Antriebsachsen verfügt, insbesondere über zwei Antriebsachsen, entlang derer es innerhalb eines Arbeitsbereiches im Wesentlichen parallel zu der Oberfläche eines Substrats bewegt wird.

Das Festlegen einer Position in oder über der Substratoberfläche wird als x-y Positionierung bezeichnet. Die Position des Werkzeugs wird anhand von Koordinaten im Steuersystem des Positionierwerkzeuges festgelegt, die im Folgenden Werkzeugkoordinaten genannt werden.

Das Positionierwerkzeug entnimmt beispielsweise ein Bauteil aus einer Abholstation und platziert dieses auf dem Substrat.

Mit einem Bilderkennungssystem können auf dem Substrat befindliche Zielmarkierungen für Bauteile oder so genannte "Fiducials" erfasst werden. Aus der erfassten Position wird die Zielposition des Positionierwerkzeuges berechnet. Eine derartige x-y Positionierung wird als Bilderkennungssystem basiert bezeichnet.

Deckt der Bildbereich des Bilderkennungssystems die gesamte Arbeitsfläche des Positionierwerkzeuges ab, so kann das Bilderkennungssystem fest bezüglich der Arbeitsfläche angebracht werden. Die Abbildung der Zielmarkierung oder einer anderen Referenzmarke hat im Bildbereich des Bilderkennungssystems eine Position mit Koordinaten, die im Folgenden Bildkoordinaten genannten werden.

Im Allgemeinen verfügt das Bilderkennungssystem jedoch selbst über Antriebsachsen, entlang derer es über das Substrat bewegt wird. Insbesondere ist das Bilderkennungssystem in der Regel parallel zur Substratoberfläche bewegbar, so dass auch eine x-y Positionierung des Bilderkennungssystems durchführbar ist. Die Position des Bilderkennungssystems wird anhand von Koordinaten im Steuersystem des Bilderkennungssystems festgelegt, die im Folgenden Kamerakoordinaten genannt werden.

Die Abbildung der Zielmarkierung kennzeichnet eine Position, die sich im Koordinatensystem des Bilderkennungssystem aus den Kamera- und den Bildkoordinaten zusammensetzt.

Das Substrat oder ein anderer Bauteilträger wird über eine Substrat-Transport-Einheit in den Arbeitsbereich des Positionierwerkzeuges, bzw. des Bilderkennungssystems, gebracht.

Die genaue Platzierung der Bauteile kann nur erfolgen, wenn die Koordinatensysteme der ursprünglich unabhängigen Systemelemente, nämlich von Substrat-Transport-Einheit, Positionierwerkzeug und Bilderkennungssystem, aufeinander abgestimmt sind.

Diese Abstimmung zwischen den Systemelementen wird im Folgenden als Kalibrierung bezeichnet.

Mit Hilfe der Kalibrierung können Abweichungen der vom jeweiligen Steuersystem angestrebten Koordinaten von den tatsächlichen Zielkoordinaten ausgeglichen werden. Die Abweichungen können hierbei durch eine Vielzahl von Ursachen hervorgerufen werden, beispielsweise durch Fertigungs- und Montageungenauigkeiten der Systemelemente, durch mangelnde Ausrichtung der Systemelemente, durch mangelnde Orthogonalität oder Skalierungsfehler der Antriebsachsen, ganz allgemein durch Nicht-Linearitäten der Antriebssysteme oder durch Schwankungen der Umgebungs- bzw. Systembedingungen (z.B. Temperatur).

Da bei der Montage von Halbleiterchips bereits Abweichungen von einigen µm zu einer unzureichenden elektrischen Kontaktierung und damit zum Funktionsausfall führen können, ist eine Kalibrierung zwingend erforderlich.

Aus dem Stand der Technik sind Kalibrierverfahren bekannt, nach denen das Positionierwerkzeug und das Bilderkennungssystem getrennt von einander auf eine gemeinsame Referenz ausgerichtet werden. Typischerweise werden die Antriebsachsen des Positionierwerkzeuges und die Antriebsachsen des Bilderkennungssystems, sowie das Bildkoordinatensystems des Bilderkennungssystems, auf die Substrat-Transport-Einheit, bzw. die Ebene, in welcher sich die Oberfläche des Substrats befindet, ausgerichtet. Bei diesen Kalibierverfahren etabliert die gemeinsame Ausrichtung anhand der Substrat-Transport-Einheit die gewünschte Abstimmung der relevanten Systemelemente.

Das Bilderkennungssystem lässt sich zum Beispiel mittels einer optischen Kalibrierungsplatte kalibrieren. Bei der optischen Kalibrierungsplatte handelt es sich typischerweise um eine Glasplatte, welche mit dem Bilderkennungssystem gut auflösbare Markierungen, z.B. in einem bestimmten Raster mit hoher Genauigkeit angeordnet, aufweist.

Die optische Kalibrierungsplatte wird anstelle eines Substrats auf der Substrat-Transport-Einheit positioniert und die Markierungen werden mit dem Bilderkennungssystem erfasst. Die tatsächlichen Koordinaten der Markierungen können mit den Koordinaten im Steuersystem des Bilderkennungssystems in Beziehung gebracht werden, wodurch eine Kalibrierung des Bilderkennungssystems bezüglich der Substratoberfläche erfolgt.

Die Kalibrierung der Kamerakoordinaten des Bilderkennungssystems kann entfallen, wenn das Bilderkennungssystem fest bezüglich des Substrats oder fest bezüglich des Positionierwerkzeuges (wie zum Beispiel in EP 1 437 933 A2 gezeigt) angebracht ist. In diesem Fall ist nur eine Kalibrierung der Bildkoordinaten erforderlich, um die Bildkoordinaten von Zielmarken in die tatsächlichen physikalischen Abmessungen umrechnen zu können.

Das Positionierwerkzeug kann zum Beispiel mittels Nadelabstichen auf einem Testsubstrat, das ebenfalls in der Substrat-Transport-Einheit positioniert wird, kalibriert werden. Eine Nadel wird in die Werkzeugaufnahme des Positionierwerkzeugs gespannt, bestimmte nominelle Werkzeugkoordinaten angefahren und mit der Nadel das Testsubstrat markiert. Die Einstichpunkte werden anschliessend beispielsweise mit einem Mikroskop untersucht. Dabei werden die tatsächlichen Koordinaten auf dem Testsubstrat vermessen und somit allgemein bezüglich der Substratoberfläche festgestellt. Die tatsächlichen Koordinaten können dann in Bezug zu den entsprechenden Koordinaten im Steuersystem des Positionierwerkzeugs gebracht werden, wodurch letzteres bezüglich der Substratoberfläche kalibriert wird.

Alternativ können Punkte oder Linien mit bezüglich der Substrat-Transport-Einheit definierter Lage von dem Positionierwerkzeug elektromechanisch mit einem Taster erfasst werden.

Es ist ausserdem bekannt, mit dem Positionierwerkzeug ein Testbauteil mit Markierungen auf einer Glasplatte zu positionieren, die sich anstelle eines Substrats in der Substrat-Transport-Einheit befindet und die ebenfalls Referenzmarken aufweist (wie zum Beispiel in US 5,537,204 A gezeigt). Die Abstände zwischen den Markierungen und den Referenzmarken dienen zum Kalibrieren des Positionierwerkzeugs. Sie können extern oder mit dem Bilderkennungssystem vermessen werden.

Andere Verfahren zum Kalibrieren eines Positionierwerkzeuges, das mit Hilfe eines Bilderkennungssystems geführt wird, wurden in EP-A-1 395 106 und in ZHENG J Y et al: "Use of an active camera for eye-hand coordination in robot manipulation", Systems & Compuersin Japan, Wiley, November 1994, pages 73-86, offenbart.

Die bekannten Kalibrierungsmethoden haben den Nachteil, dass für die jeweilige Kalibrierung besonders ausgestaltete Testplatten, Test-Substrate oder Glasplatten, in die Substrat-Transport-Einheit eingebracht werden müssen, wobei eine reproduzierbare Positionierung nicht garantiert werden kann. Derartige Verfahren erfordern eine in der Regel aufwendige Umrüstung und können nur vor der Inbetriebnahme oder in festgelegten Serviceabständen erfolgen.

Alle bisher bekannten Methoden erfordern den Einsatz von zusätzlichen Lehren und Hilfsmitteln, wie Testplatten, Testbauteilen, Nadelhalter, Mikroskop, Kamera etc., die zum einen selbst wieder Quellen für Abweichungen darstellen, zum anderen einen nicht unerheblichen Kostenaufwand verursachen. Dies gilt insbesondere für die verwendeten optischen Kalibrier- oder Testplatten, welche die komplette Arbeitsfläche von dem Positionierwerkzeug und/oder Bilderkennungssystem abdecken müssen. Schliesslich erlauben diese Verfahren eine Kompensation zeitlich veränderlicher, zumeist thermisch bedingter, Abweichungen der Systemkomponenten entweder gar nicht oder nur mit einer Unterbrechung des Produktionsbetriebs.

Es ist die Aufgabe der Erfindung, Vorrichtungen und Verfahren vorzustellen, mit denen die Nachteile aus dem Stand der Technik überwunden werden, welche die Kalibrierung eines Positionierwerkzeugs bezüglich einer externen Referenz vermeiden und die eine präzise und dabei im Hinblick auf Kosten und Aufwand günstige Kalibrierung eines Positioniersystems erlauben. Darüber hinaus ist es die Aufgabe der Erfindung, die Kalibrierung eines Positionierwerkzeugs auch während des Produktionsbetriebes ohne konzeptionellen Mehraufwand zu überprüfen und/oder zu erneuern und somit zeitlich veränderlichen Abweichungen Rechnung zu tragen.

Die Aufgaben werden erfindungsgemäss gelöst durch ein Verfahren zum Kalibrieren der x-y Positionierung eines Positionierwerkzeuges mit den Merkmalen in Anspruch 1.

Das Positionierwerkzeug ist über einer Arbeitsfläche positionierbar und nimmt dabei innerhalb eines Steuersystems des Positionierwerkzeugs Werkzeugkoordinaten ein. Das Bilderkennungssystem dient in einem Betriebsmodus zum Erfassen von Zielmarkierungen auf der Arbeitsfläche. Die x-y Positionierung des Positionierwerkzeuges wird bezüglich der Koordinaten des Bilderkennungssystems kalibriert, indem in einem Kalibriermodus das Positionierwerkzeugs auf einen Rasterpunkt positioniert wird und die Werkzeugkoordinaten des Rasterpunkts erfasst werden. Anschliessend wird eine in definierter Lage zum Positionierwerkzeug angeordnete Referenzmarke mit dem Bilderkennungssystems erfasst und die Koordinaten der Referenzmarke werden bezüglich des Bilderkennungssystems ermittelt.

Um einer beliebigen ortsabhängigen Beziehung zwischen Werkzeugkoordinaten und Koordinaten im Bilderkennungssystem gerecht zu werden, kann die Erhebung von Werkzeugkoordinaten und Koordinaten im Bilderkennungssystem in nachfolgenden Schritten an weiteren Rasterpunkten wiederholt werden. Aufgrund von nicht-linearen Eigenschaften der jeweiligen x-y Positionierung ergibt sich in der Regel ein nicht-linearer Zusammenhang zwischen den gemessenen Koordinatentupeln.

Alternativ oder zusätzlich kann die Erhebung auch, beispielsweise zum Zwecke einer Mittelung, an den gleichen Rasterpunkten wiederholt werden. Die Messung kann an demselben Rasterpunkt mehrmals hintereinander erfolgen, um über lokale Fluktuationen, zum Beispiel aufgrund von Belichtungseffekten, zu mitteln. Der nominell gleiche Rasterpunkt kann auch mehrmals von den Antriebssystemen angesteuert werden. Dies kann dazu dienen, über Fluktuationen aufgrund mangelnder Reproduzierbarkeit der Antriebssysteme zu mitteln.

Abschliessend werden die Werkzeugkoordinaten und die Koordinaten im Bilderkennungssystem der jeweiligen Rasterpunkte mit einander in Bezug gesetzt und/oder abgeglichen.

Unter dem Abgleich von Daten versteht man das Vergleichen der Datenbestände, um den Zusammenhang zwischen ihnen aufzuspüren und auf weitere Datenpunkte zu übertragen. In der Regel weicht der tatsächlich vorliegende Zusammenhang zwischen den Daten von einem modellgemässen Zusammenhang, der beispielsweise einer Konstruktionszeichnung entnehmbar ist, ab.

Das Bilderkennungssystem kann fest über der Arbeitsfläche angeordnet sein. Die Koordinaten der Referenzmarke im Bilderkennungssystem ergeben sich dann aus den Bildkoordinaten.

In einer bevorzugten und allgemein anwendbaren Ausführung des Verfahrens ist das Bilderkennungssystems unabhängig vom Positionierwerkzeug über der Arbeitsfläche insbesondere in x-y-Richtung positionierbar und nimmt dabei im Steuersystem des Bilderkennungssystems Kamerakoordinaten ein. Das Bilderkennungssystem wird jeweils nach der Positionierung des Positionierwerkzeuges an einen entsprechenden Rasterpunkt nachgeführt und die Koordinaten der Referenzmarke im Bilderkennungssystem werden mittels der Kamerakoordinaten und der Bildkoordinaten der Referenzmarke festgestellt.

Durch die definierten Lage der Referenzmarke zum Positionierwerkzeug und die Erfassung von immer derselben Referenzmarke mit dem Bilderkennungssystem können die Rasterpunktkoordinaten im Steuersystem des Positionierwerkzeugs und die Rasterkoordinaten im Steuersystem des Bilderkennungssystems eindeutig zueinander zugeordnet werden.

Nach der Zuordnung und/oder dem Abgleich der erfassten Koordinaten ist es umgekehrt möglich, das Positionierwerkzeug exakt an einen Ort zu bringen, der zuvor in den Koordinaten des Bilderkennungssystems festgelegt wurde, beispielsweise nach Erfassen einer Zielmarkierung auf einem Substrat. Das Positionierwerkzeug ist somit bezüglich des Bilderkennungssystems kalibriert.

Im Gegensatz zu dem aus dem Stand der Technik bekannten Verfahren basiert die erfindungsgemässe Kalibrierung somit nicht auf einer jeweiligen Ausrichtung des Bilderkennungssystems und des Positionierwerkzeugs an einer von ihnen unabhängigen Referenz, sondern auf einer Vermessung der x-y Positionierung des Werkzeuges mit und somit bezüglich des Bilderkennungssystems.

Das Verfahren wird bevorzugt vollautomatisiert durchgeführt. Es können beispielsweise die Abfolge der Rasterpunkte und die Anzahl der Messungen an einem Rasterpunkt vorab festgelegt sein.

Ein Einsetzen oder Austauschen von Lehren, Massstäben, Kalibriersubstraten oder -bauteilen ist nicht notwendig.

Eine Abfolge von Rasterpunkten kann vor der Kalibrierung festgelegt worden sein. Die Datenerhebung kann an Rasterpunkten erfolgen, die gleichmässig über den gesamten Arbeitsbereich des Positionierwerkzeuges verteilt sind. Es kann auch in bestimmten ausgewählten Bereichen, an denen typischerweise Platzierungen vorgenommen werden und Zielmarkierung angeordnet sind, eine höhere Dichte von Rasterpunkten vorgesehen sein.

Die Anordnung und Dichte der Rasterpunkte kann frei konfigurierbar sein, sodass das Kalibrierverfahren an die jeweilige Genauigkeitsanforderung und Applikationen, zum Beispiel unterschiedliche Substratgrössen, Bauteilgrössen und/oder -abstände, anpassbar ist.

Die Kalibrierung kann ohne grossen Aufwand praktisch jederzeit durchgeführt werden. Zeitlich veränderliche Schwankungen, hauptsächlich thermisch bedingt, können mit Hilfe von sogenannten Rekalibrierungen ausgeglichen werden. Diese können im Produktionsbetrieb von Zeit zu Zeit ohne nennenswerte Durchsatzeinbussen durchgeführt werden. Bei der Rekalibrierung können dieselben Rasterpunkte wie bei der ersten Kalibrierung angesteuert werden, es können andere Rasterpunkte gewählt werden oder die Rasterpunkte werden an die bevorzugten Platzierungsbereiche angepasst.

Eine Rekalibrierung kann nach bestimmten vorher festgelegten Zeitintervallen erfolgen. Die Zeitintervalle können auch an den Betrieb der Maschine angepasst werden. Beispielsweise können in der Warmlaufphase, in der grössere thermische Änderungen zu erwarten sind, oder nach einer Unterbrechung des Produktionsbetriebes Kalibrierungen in kürzeren zeitlichen Abständen als in dem anschliessenden Dauerbetrieb erfolgen.

Die Zeitabstände zwischen den Rekalibrierungen können auch in Abhängigkeit von deren Ergebnissen, das heisst adaptiv, festgelegt werden. Werden grosse Abweichungen zwischen aufeinander folgenden Messungen registriert, so erfolgt die nächste Rekalibrierung nach einem kürzeren Zeitintervall und umgekehrt. Unnötig häufige und somit den Produktionsdurchsatz herabsetzenden Rekalibrierungsmessungen können so vermieden werden.

Durch einen laufenden Vergleich neu erhobener Daten mit früheren Ergebnissen lassen sich zeitlich veränderliche Abweichung erkennen und im Produktionsbetrieb berücksichtigen.

Ausser der Position der Referenzmarke kann auch die Ausrichtung der Referenzmarke erfasst werden, die zeit- und/oder ortabhängig sein kann. Für jeden Rasterpunkt kann auf diese Weise auch eine Winkelinformation ermittelt werden, die im Betriebsmodus für die Einstellung der Ausrichtung des Positionierwerkzeuges eine Rolle spielen kann. Im Betriebesmodus wird dann nicht nur die Position einer Zielmarkierung sondern auch die Ausrichtung abgefragt und entsprechend die Position und die Ausrichtung des Positionierwerkzeuges eingestellt.

Der Abgleich der erfassten Koordinaten kann auf unterschiedliche Weise erfolgen. In einer bevorzugten Variante wird eine Nachschlagtabelle erstellt, mit welcher Koordinaten von Rasterpunkten im Steuersystem des Bilderkennungssystems, d.h. Kamerakoordinaten, in Bezug zu den Koordinaten der Rasterpunkte im Steuersystem des Positionierwerkzeug, d.h. Werkzeugkoordinaten, und/oder den Koordinaten der Referenzmarke an den jeweiligen-Rasterpunkten im Koordinatensystem des Bilderkennungssystems, d.h. Bildkoordinaten, gestellt werden. Dazu können an jedem Rasterpunkt die erfassten Bildkoordinaten über mehrere direkt hintereinander ausgeführte Messungen gemittelt werden und/oder die Koordinaten der Referenzmarke über mehrere Messungen gemittelt werden, für welche die nominellen Koordinaten des Rasterpunkts von dem Positionierwerkzeug wiederholt angesteuert werden.

Im Hinblick auf zeitabhängige Zusammenhänge zwischen den jeweiligen Koordinaten kann eine adaptive Kalibrierung vorgenommen werden, indem die Nachschlagtabellen zusammen mit den Zeitpunkten der Messung gespeichert werden und für eine Auswertung im Hinblick auf zeitabhängige Verläufe verwendet werden.

In die Nachschlagtabelle kann ausserdem für jeden Rasterpunkt die Ausrichtung der Referenzmarke eingetragen werden.

Ausgehend von den Koordinaten einer Zielmarke im Bilderkennungssystem, das heisst ausgehend von den Kamera- und Bildkoordinaten einer Zielmarke kann der entsprechende Ort im Steuersystem des Positionierwerkzeuges aus der Nachschlagtabelle abgelesen werden. Hat der gewünschte Ort keine der erfassten Rasterkoordinaten, so kann die Zuordnung durch Interpolation von benachbarten, erfassten Rasterkoordinaten erfolgen.

Prinzipiell kann auch eine Nachschlagtabelle erstellt werden, die der Positioniergenauigkeit entspricht. Dazu werden mit Interpolation aus erfassten Rasterkoordinaten Tabelleneinträge generiert. Die Dichte der Rasterpunkte, die zu den erfassten und berechneten Rasterkoordinaten gehören, entspricht der Positioniergenauigkeit. Diese kann an die Genauigkeit angepasst werden, mit welcher das Positionierwerkzeug und das Bilderkennungssystem gesteuert werden können.

Bei der Interpolation kann ein lineares oder ein nicht lineares Interpolationsverfahren verwendet werden.

Dieselben Verfahren können auch auf Winkelinformationen, die sich auf die Anpassung der Ausrichtung von Zielmarkierungen und Positionierwerkzeug beziehen, abgewendet werden.

Die Aufgaben werden erfindungsgemäss weiterhin gelöst durch ein Verfahren zum Kalibrieren eines Bilderkennungssystem basierten Positioniersystems, insbesondere mit einem "Pick and Place" - Werkzeug zum Platzieren eines Bauteils auf einem Substrat mit den Merkmalen im Anspruch 6.

Dieses Verfahren umfasst die folgenden Schritte. Zunächst erfolgt eine Kalibrierung der Bildkoordinaten des Bilderkennungssystems bezüglich einer Referenzebene, d.h. einer Ebene auf welche das Bilderkennungssystem optimiert ist und somit zu einer scharfen Abbildung von Zielmarkierungen führt. Hierbei handelt es sich insbesondere um eine Ebene, in der die Oberfläche des Substrats liegt, auch Substratebene genannt.

Unter der Kalibrierung der Bildkoordinaten ist hierbei eine Zuordnung zwischen Punkten im Bildkoordinatensystem und entsprechenden tatsächlichen physikalischen Abmessungen in der Referenzebene zu verstehen.

Anschliessend wird die x-y Positionierung des Positionierwerkzeuges bezüglich des Bilderkennungssystems kalibriert, insbesondere gemäss einem der oben beschriebenen Verfahren.

Auf eine Kalibrierung des Positionierwerkzeuges bezüglich eines separaten Referenzobjekts wird wiederum verzichtet. Die Kalibrierung des Positionierwerkzeuges erfolgt bevorzugt über mindestens eine mit dem Positionierwerkzeug verbundene und vom Bilderkennungssystem erfassbare Referenzmarke.

Die Aufgaben werden erfindungsgemäss weiterhin gelöst durch ein Verfahren zum Platzieren eines Bauteils auf einem Substrat, mit einem Positionierwerkzeug, insbesondere einem "Pick und Place"-Werkzeug, und einem Bilderkennungssystem mit den Merkmalen in Anspruch 7.

Zu Beginn kann eine Kalibrierung der Bildkoordinaten des Bilderkennungssystems bezüglich einer Referenzebene, insbesondere der Substratebene erfolgen.

Das weitere Verfahren umfasst nun die folgenden Verfahrensschritte. Zunächst wird in einem ersten Schritt (i) die x-y Positionierung des Positionierwerkzeuges bezüglich des Bilderkennungssystems kalibriert, insbesondere gemäss einem wie oben beschriebenen Verfahren, danach erfolgt in einem zweiten Schritt (ii) die Erfassung einer auf dem Substrat angebrachten Zielmarkierung mit dem Bilderkennungssystem und die Ermittlung der Koordinaten der Zielmarkierung im Bilderkennungssystem, in einem dritten Schritt (iii) die Bestimmung der Werkzeugkoordinaten des Positionierwerkzeugs aus den Koordinaten der Zielmarkierung im Bilderkennungssystem unter Verwendung der in Schritt (i) vorgenommen Kalibrierung und in einem vierten Schritt (iv) die Positionierung des Positionierwerkzeugs. Die Schritte können ab dem ersten oder zweiten Verfahrensschritt wiederholt werden.

Wird während des Produktionsablaufs das Verfahren ab dem ersten Schritt wiederholt, so handelt es sich um eine Rekalibrierung.

Die Bestimmung der Werkzeugkoordinaten, also der Koordinaten im Steuersystem des Positionierwerkzeugs, aus den Koordinaten der Zielmarkierung im Bilderkennungssystem, erfolgt aufgrund der mit der Kalibrierung gewonnenen Zuordnungen.

Während des Verfahrens kann das Positionierwerkzeug selbstverständlich weitere Bewegungen und Aktionen durchführen, beispielsweise zur Aufnahme, zur Kontrolle, zur Bearbeitung und/oder zum Ablegen eines Bauteils. Das Verfahren kann jederzeit beendet werden.

In einem vorteilhaften Verfahren findet eine erneute Kalibrierung nach einem festen, einem konfigurierbaren oder einem adaptiven Zeitintervall oder nach einer festen, einer konfigurierbaren oder einer adaptiven Anzahl von Positionierungen statt.

Adaptiv bedeutet in diesem Zusammenhang, dass die Anzahl oder das Zeitintervall in Abhängigkeit von Ergebnissen früherer Kalibrierungen oder äusserer Einflüsse, zum Beispiel von Temperaturverläufen, vorgenommen wird.

Die Aufgaben werden erfindungsgemäss weiterhin gelöst durch ein Verfahren zum Rekalibrieren bei dem Positonieren eines Bauteils auf einem Substrat mit einem Positionierwerkzeug, insbesondere einem "Pick und Place"-Werkzeug, und einem Bilderkennungssystem, mit den Merkmale im Anspruch 11, welches die folgenden Verfahrensschritte umfasst. Zunächst erfolgt in einem ersten Schritt (i) eine Erfassung einer auf dem Substrat angebrachten Zielmarkierung mit dem Bilderkennungssystem und Ermittlung der Koordinaten der Zielmarkierung im Bilderkennungssystem. Nachfolgend werden in einem zweiten Schritt (ii) die Werkzeugkoordinaten des Positionierwerkzeugs (1) aus den Koordinaten der Zielmarkierung im Bilderkennungssystem bestimmt. Danach erfolgt in Schritt (iii) die Positionierung des Positionierwerkzeugs.

Anschliessend wird in einem Schritt (iv) eine in definierter Lage zum Positionierwerkzeug (1) angeordnete Referenzmarke (14) mit dem Bilderkennungssystem (2) erfasst und in einem Schritt (v) werden die Koordinate der Referenzmarke (14) bezüglich des Bilderkennungssystems ermittelt. In einem weiteren Schritt (vi) erfolgt ein Vergleich der ermittelten Koordinaten mit den zu erwartenden Koordinaten der Referenzmarke und/oder des Positioniersystems. Mit dem Vergleich wird festgestellt, ob zwischen den ermittelten und den zu erwartenden Koordinaten eine Übereinstimmung oder eine Abweichung besteht. Falls eine Abweichung vorliegt, die über einen vorgegebenen Toleranzbereich hinausgeht, wird für eine nachfolgende Bestimmung der Werkzeugkoordinaten eine Korrektur festgelegt.

Für die Festlegung der Korrektur wird bevorzugt die Grösse und Richtung der Abweichung zugrunde gelegt.

Die zu erwartenden Koordinaten der Referenzmarke ergeben sich aus einem früheren Messschritt, beispielsweise anhand von vorher bei einem entsprechenden Rekalibrierungsverfahren ermittelten Koordinaten.

Alternativ können die zu erwartenden Koordinaten der Referenzmarke aus den in Schritt (ii) festgelegten Werkzeugkoordinaten und der definierten Lage der Referenzmarke zu dem Werkzeug bestimmt werden. Diese werden dann mit den ermittelten Koordinaten verglichen.

Liegt die Abweichung ausserhalb eines vorher festgelegten Toleranzbereichs, so kann sie für eine Korrektur bei der nächstfolgenden Bestimmung der Werkzeugkoordinaten in Bezug auf eine Zielmarkierung verwendet werden.

Alternativ oder zusätzlich kann aus den mit dem Bilderkennungssystem ermittelten Koordinaten der Referenzmarke auf die Koordinaten des Werkzeugs zurück geschlossen werden. Ein Vergleich kann dann zwischen den angesteuerten Werkzeugkoordinaten und den über die Referenzmarke ermittelten Werkzeugkoordinaten erfolgen. Auch in diesem Fall kann eine Abweichung, die ausserhalb eines Toleranzbereichs liegt, für eine Korrektur bei einer nachfolgenden Bestimmung der Werkzeugkoordinaten verwendet werden.

Das Verfahren kann mit dem ersten Schritt (i) fortgesetzt werden.

Anstelle eines vollständigen Kalibrierungsverfahrens wird lediglich punktuell überprüft, ob das Werkzeug die korrekten Koordinaten ansteuert. Die Überprüfung findet an den Orten statt, die durch die Zielmarkierungen vorgegeben werden.

Bei einer Serienproduktion werden nachfolgend stets Substrate mit denselben oder zumindest analogen Zielmarkierungen bestückt, sodass eine vollständige Kalibrierung bezüglich der gesamten Substratfläche nicht nötig ist.

Die Rekalibirierung bezüglich des Bilderkennungssystems kann alternativ als komplette Kalibrierung, insbesondere gemäss einem weiter oben beschriebenen Verfahren, vorgenommen werden.

Auf eine Kalibrierung vor einer ersten x-y Positionierung kann verzichtet werden, wenn akzeptiert werden kann, dass die Positionierung bei den ersten durchlaufenden Substraten zu Abweichungen zwischen zu erwartenden und ermittelten Koordinaten führt. Diese Abweichungen nehmen aufgrund der durch die Rekalibrierungen erfolgenden Korrekturen während des Betriebes ab.

In einem nach Schritt (iii) erfolgenden Schritt kann zusätzlich nachgeprüft werden, ob eine Rekalibrierung überhaupt notwendig ist. Falls dies nicht der Fall ist, kann das Verfahren mit dem ersten Schritt (i) fortgesetzt werden. In dem Prüfschritt kann beispielsweise abgefragt werden, ob eine bestimmte Anzahl von Positionierungen vorgenommen wurde, nach der eine erneute Rekalibrierung vorgenommen werden soll oder ob die Betriebsdauer ein bestimmtes Zeitintervall überschritten hat, nach dem eine erneute Rekalibrierung vorgenommen werden soll. Es kann auch abgefragt werden, ob sich äussere Bedingungen verändert haben, ob die Qualität der Positionierung genügend gut ist oder ob Substrate mit Zielmarkierungen an anderen Orten als bislang bestückt werden sollen. Eine Rekalibrierung kann auch in Abhängigkeit von den Ergebnissen früherer Rekalibiervorgänge vorgenommen werden.

Auch im Verlauf dieses Verfahrens kann das Positionierwerkzeug selbstverständlich weitere Bewegungen und Aktionen durchführen, beispielsweise zur Aufnahme, zur Kontrolle, zur Bearbeitung und/oder zum Ablegen eines Bauteils. Das Verfahren kann jederzeit beendet werden.

Die Aufgaben werden in vorrichtungsmässiger Hinsicht erfindungsgemäss gelöst durch eine Vorrichtung mit einem Positionierwerkzeug, insbesondere einem "Pick und Place"-Werkzeug zum Platzieren eines Bauteils auf einem Substrat, und einem Bilderkennungssystem zum Erfassen von auf einem Substrat angeordneten Zielmarkierungen.

Dabei weist die Vorrichtung zum Kalibrieren der x-y Positionierung des Positionierwerkzeugs mindestens eine von dem Bilderkennungssystem erfassbare Referenzmarke auf, die bezüglich des Positionierwerkzeugs mindestens eine definierte und/oder feste Position besitzt.

Zur Bestimmung der Ortskoordinaten des Positionierwerkzeugs im Bilderkennungssystem ist es notwendig, dass die von dem Bilderkennungssystem erfasste Referenzmarke eine vorbestimmte Lage bezüglich des Positionierwerkzeugs besitzt. Die Lage der mindestens einen Referenzmarke kann einstellbar sein, vorzugsweise wird sie jedoch nur einmal eingerichtet und bleibt während des gesamten Betriebes fest bezüglich des Positionierwerkzeugs.

Die Koordinaten der Referenzmarke und somit des Positionierwerkzeuges können in einem Kalibriermodus bezüglich des Positionierwerkzeugs und des Bilderkennungssystems erfasst und mit den Koordinaten des Bilderkennungssystems in Bezug gesetzt und/oder abgeglichen werden. Auf diese Weise wird das Positionierwerkzeug bezüglich des Bilderkennungssystems kalibriert.

Auf eine unabhängige Kalibrierung des Positionierwerkzeugs, bzw. einen Vergleich mit einem Massstab wird verzichtet. Stattdessen wird das Bilderkennungssystem, das im Maschinenbetrieb auch die Zielposition eines Bauteils in der Arbeitsfläche ermittelt, als Messsystem zur Kalibrierung verwendet. Der Einsatz von zusätzlichen Kalibrierplatten und Messmitteln für die Kalibrierung des Positionierwerkzeugs wird vermieden.

In einer vorteilhaften Ausführungsform ist die mindestens eine Referenzmarke auf einem Träger, insbesondere auf einem mit dem Positionierwerkzeug fest verbundenen Träger, angebracht. Die Referenzmarke befindet sich somit auf einem separaten Bauteil. Der Träger kann in das optische Feld des Bilderkennungssystems gebracht werden, vorteilhafterweise ist er jedoch fest mit dem Positionierwerkzeug verbunden, wodurch die Referenzmarke eine zum Positionierwerkzeug definierte Lage hat.

Die Anordnung der Referenzmarke auf einem separaten Bauteil ermöglicht die Nachrüstung des Positioniersystems mit einer Referenzmarke zum Kalibrieren der x-y Positionierung.

Der Träger ist bevorzugt so an dem Positionierwerkzeug angebracht, dass die Referenzmarke im gesamten Arbeitsbereich vom Bilderkennungssystem erfassbar ist. Es könne auch mehrere Träger vorgesehen sein, die unterschiedliche Lagen jeweiliger Referenzmarken definieren.

Damit die Referenzmarke auch an den Rändern eines Substrats bzw. der Arbeitsfläche noch erfasst werden kann, sollte sich die Marke nicht zu weit von der Mitte des Positionierwerkzeugs entfernt befinden. Andernfalls könnte die Referenzmarke am Rand des Substrats aus dem Arbeitsbereich des Bilderkennungssystems, der in der Regel an den Arbeitsbereich des Positionierwerkzeugs und die Abmessungen des Substrats angepasst ist, herausreichen.

Der Träger ist bevorzugt so ausgelegt, dass die Referenzmarke im Bildbereich des Bilderkennungssystems liegt, wenn dieses sich mittig über dem Positionierwerkzeug befindet. Andernfalls muss bei der Kalibrierung ein entsprechender Versatz zwischen der Position des Bilderkennungssystems und des Positionierwerkzeugs berücksichtigt werden.

Eine präzise Positionierung kann nur dann vorgenommen werden, wenn die Zielmarkierung scharf durch das Bilderkennungssystem abgebildet wird. Bilderkennungssysteme zur Erfassung von Zielmarkierungen auf Substraten sind daher in der Regel mit einer festen Brennweite ausgestattet, die auf die Entfernung zwischen dem Bilderkennungssystems und der Substratebene angepasst ist. Die Kalibrierung ist umso genauer, je präziser die Position der Referenzmarke durch das Bilderkennungssystem festgestellt wird.

Eine bevorzugte konstruktive Ausführung ergibt sich daher, wenn die mindestens eine Referenzmarke in einer Ebene in unmittelbarer Nähe zum Substrat angeordnet ist. Damit befindet sich die Referenzmarke nahe an einer Referenzebene, in der Regel die Substratebene, bezüglich derer die Brennweite des Bilderkennungssystems optimiert ist, und kann scharf abgebildet werden.

Die Referenzmarke kann bevorzugt derart an dem Positionierwerkzeug angebracht werden, dass sie sich in einer Ebene unmittelbar oberhalb des von dem Positionierwerkzeug transportierten Bauteils befindet. Damit kann die Referenzmarke nah an die Substratebene herangeführt werden, ohne mit dem zu platzierenden Bauteil zu kollidieren.

Weitere Vorteile ggf. auch unabhängige von den vorstehend beschriebenen Verfahren können erreicht werden durch eine Kalibriervorrichtung zum Kalibrieren der x-y Positionierung eines Bilderkennungssystem basierten Positionierwerkzeuges, insbesondere eines "Pick und Place"- Werkzeuges zum Platzieren eines Bauteils auf einem Substrat, insbesondere in einer wie weiter oben beschriebenen Vorrichtung, mit den Merkmalen des Anspruchs 12.

Die Kalibriervorrichtung weist mindestens ein optisches System, insbesondere aus mindestens einer Linse bestehend, auf, welches derart mit einer Referenzmarke verbindbar ist, dass die mindestens eine Referenzmarke mit dem mindestens einen optischen System derart durch das Bilderkennungssystem abbildbar ist, dass die Abbildung derjenigen einer Referenzmarke entspricht, die, insbesondere an gleicher x-y Position, in einer Referenzebene, insbesondere einer Ebene in unmittelbarer Nähe des Substrats, insbesondere die Substratebene, liegt und die ohne das optisches System abgebildet wird.

Bei dem Positionierwerkzeug kann es sich um ein "Pick-und-Place"- Werkzeug handeln, aber auch um jedes andere Werkzeug, für das eine exakte x-y-Positionierung notwenig ist, wie zum Beispiel eine Positioniervorrichtung zum Aufbringen von Klebstoffen oder Klebefolien.

Erfindungsgemäss kann das Bilderkennungssystem nicht nur zum Erfassen einer Zielmarkierung auf dem Substrat genutzt werden, sondern auch zum Abbilden und Erfassen einer Referenzmarke, die vorteilhafterweise in einem definierten Zusammenhang mit dem Positionierwerkzeug steht. Für einen präzisen Kalibriervorgang muss die Referenzmarke so scharf durch das Bilderkennungssystem abgebildet werden, wie die Zielmarkierung.

Das Bilderkennungssystem ist in der Regel mit einer festen Brennweite ausgestattet, die für das Erfassen der Zielmarkierungen auf den Abstand zu einer Referenzebene, in der Regel die Substratebene, eingestellt ist. Kann die Referenzmarke aufgrund baulicher Gegebenheiten nicht in der unmittelbaren Nähe der Substratebene angebracht werden, so sorgt das optische System der Kalibriervorrichtung dafür, dass die Referenzmarke trotzdem ebenso scharf abgebildet wird, als läge sie in der Referenzebene.

Das optische System kann zur Erfassung der Referenzmarke zwischen die Referenzmarke und das Bilderkennungssystem gebracht werden.

Vorteilhafterweise ist die Kalibriervorrichtung mit dem Positionierwerkzeug verbunden, steht in einer festen räumlichen Beziehung zu dem Werkzeug und wird stets mitbewegt, wenn das Positionierwerkzeug zu Arbeits- oder Kalibrierzwecken bewegt wird. Eine unabhängige Halterung und ein separater Antrieb für die Kalibriervorrichtung sind nicht notwendig.

Das optische System kann in einer vorteilhaften Ausführung fest mit der Referenzmarke verbunden sein, so dass Referenzmarke und optisches System in einer festen räumlichen Beziehung stehen und keine Fehlerquelle durch eine relative Positionierung von Referenzmarke und optischem System entsteht. Bevorzugt bilden Referenzmarke und optisches System eine bauliche Einheit. So kann eine Referenzmarke direkt in das optische System integriert sein, beispielsweise einer Linse des optischen Systems aufgezeichnet, aufgeklebt, eingeritzt oder eingeätzt sein.

Die Referenzmarke kann sich auf einem Träger befinden und einen lateralen Abstand von der zu bestimmenden Koordinate des Werkzeuges haben. Der Abstand sollte jedoch nicht zu gross sein. Zum einen besteht die Gefahr, dass der Träger aus dem Arbeitsbereich des Positionierwerkzeuges herausragt, wenn dieses am Rand des vorgesehenen Arbeitsbereiches positioniert ist, worauf hin sich die Referenzmarke gegebenenfalls nicht mehr im Arbeitsbereich des Bilderkennungssystems befindet. Zum anderen unterliegt der Träger selbst thermischen Schwankungen, die umso grösser sind, je grösser die Ausdehnung des Trägers ist. Vorteilhafterweise sind die Referenzmarke und/oder das Kalibriersystem daher auf dem Positionierwerkzeug angeordnet

Das Positionierwerkzeug ist zumeist mit Funktionalitäten ausgestattet, die mehr als eine reine x-y- Positionierung erlauben. Zum Beispiel kann das Werkzeug in der Lage sein, Winkelkorrekturen bis hin zu Rotationen des Bauteils um 180 Grad sowie Tiltkorrekturen auszuführen. In das Werkzeug kann ausserdem eine Heizung integriert sein. Die zusätzlichen Funktionalitäten können zu einer erheblichen räumlichen Ausdehnung des Positionierwerkzeuges führen. Ein Träger für eine Referenzmarke, die sich in einer Ebene in unmittelbarer Nähe des Substrats befindet, müsste daher unter Umständen sehr lang sein und würde womöglich nicht mehr in dem Bildbereich des Bilderkennungssystems liegen, wenn dieses mittig über dem Positionierwerkzeug angeordnet ist.

Vorteilhafterweise ist eine Referenzmarke daher, bevorzugt mittig, auf dem Positionierwerkzeug angeordnet, was mittels der beschriebenen Kalibriervorrichtung und des darin enthaltenen optischen Systems problemlos möglich ist. Dies führt zudem zu einer kompakten baulichen Anordnung. Thermisch bedingte Veränderungen der relativen Lage von Positionierwerkzeug und der Referenzmarke können somit weitestgehend verhindert werden.

Bei der Kalibrierung geht es vorwiegend darum, Koordinaten eines bestimmten Punktes des Positionierwerkzeuges in Bezug zum Bilderkennungssystem zu setzen. Geeignet dafür ist beispielsweise ein zentraler Punkt, durch den die Hebeachse eines Pick- und Place - Werkzeuges verläuft. Auf dieser befindet sich zum Beispiel eine Düse mit Vakuum- bzw. Druckanschluss für das Aufnehmen bzw. Absetzen von Bauteilen oder eine Dosiernadel für das Aufbringen von Klebstoff.

In einer vorteilhaften Ausführung ist die Referenzmarke auf einer Achse angeordnet, die parallel zur optischen Achse des Bilderkennungssystems und durch einen derartigen zentralen Punkt des Positionierwerkzeug verläuft, insbesondere durch die Düse des "Pick und Place"- Werkzeugs.

Die optische Achse des Bildererkennungssystems verläuft in der Regel senkrecht zur Substratebene.

Die Achse, die durch den zentralen Punkt und die Referenzmarke, insbesondere einen bestimmten Schwerpunkt der Referenzmarke, definiert ist, fällt mit der optischen Achse des Bilderkennungssystem zusammen, wenn dieses mittig über dem Positionierwerkzeug angeordnet ist. Die Referenzmarke repräsentiert in diesem Fall bei einer Erfassung durch das optische System die Position des zentralen Punktes.

Häufig wird eine Neukalibrierung nach einer Umrüstung eines Positioniersystems notwenig. Die Abstände der einzelnen Elemente des Systems können sich dabei verändern. In einer vorteilhaften Ausgestaltung der Erfindung sind daher die Abbildungseigenschaften des optischen Systems verstellbar. Damit kann das optische System beispielsweise zur Kalibrierung mit verschiedenen Referenzmarken in verschiedenen Abständen zur Referenzebene verwendet werden oder zur Kalibrierung mit unterschiedlichen Positionierungswerkzeugen oder unterschiedlichen Bilderkennungssystemen eingesetzt werden.

Zum Beispiel kann eine Abstandsjustage zwischen dem Linsensystem und der Referenzmarke vorgesehen sein, wobei beispielsweise ein Objektiv ein Aussengewinde aufweist und ein Halter für eine Referenzmarke mit einem entsprechenden Innengewinde ausgestattet ist.

Vorteilhafterweise ist die Referenzmarke mit Mitteln zur Beleuchtung oder zum Leuchten versehen. Die Referenzmarke muss in diesem Fall für eine optische Erfassung nicht von einer externen Beleuchtung angestrahlt werden. Darüberhinaus ist die Beleuchtung dann unabhängig von der Positionierung des Werkzeugs und des Bilderkennungssystems. -

Bevorzugt kennzeichnet die Referenzmarke mindestens einen Punkt und/oder mindestens eine Ausrichtung, die insbesondere in Form eines Kreuzes vorliegt. Mit der Kennzeichnung eines Punktes lässt die Referenzmarke die Bestimmung einer ausgezeichneten Schwerpunktsposition zu, mit der Kennzeichnung einer Ausrichtung eine Winkelinformation. Anhand der Referenzmarke kann die Winkeltreue direkt überprüft werden oder die Referenzmarke kann zur Kalibrierung eines Positionierwerkzeuges mit rotatorischem Freiheitsgrad genutzt werden.

Die Erfindung ist im Folgenden in Ausführungsbeispielen anhand von Zeichnungen näher erläutert.

Es zeigen
- Figur 1: eine schematische perspektivische Ansicht eines Bilderkennungssystem basierten Positioniersystems;
- Figur 2: eine schematische Darstellung eines Kalibrierverfahrens;
- Figur 3: eine schematische Seitenansicht eines Positionierwerkzeuges;
- Figur 4: eine zweite schematische Seitenansicht eines Positionierwerkzeuges mit einer Vorrichtung zum Kalibrieren;
- Figur 5: eine schematische perspektivische Ansicht einer Vorrichtung zum Kalibrieren.

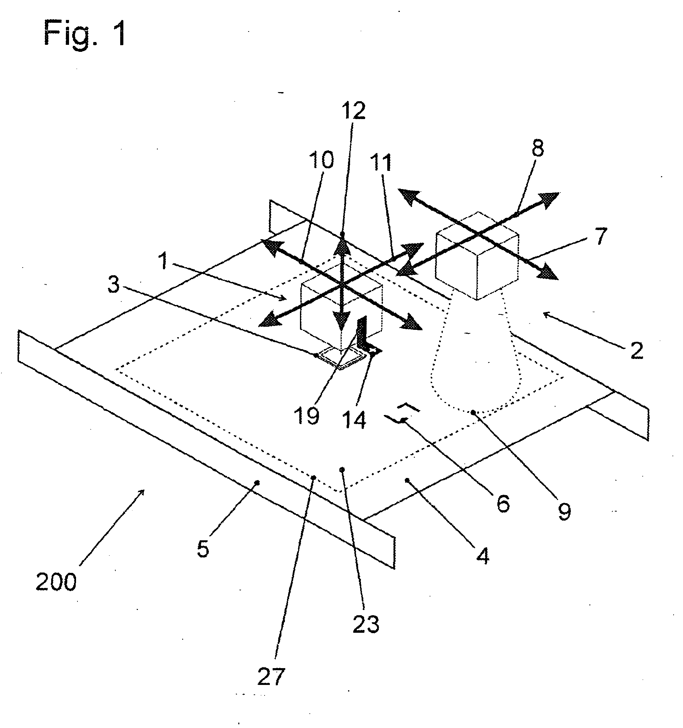

Figur 1 zeigt die schematische perspektivische Ansicht eines Positioniersystems 200, mit einem Bilderkennungssystem 2 und einem Positionierwerkzeug 1, bei dem es sich um ein "Pick-und-Place"-Werkzeug 1 handeln kann, mit dem ein Bauteil 3 auf einem Substrat 4 platziert wird. Das Substrat 4 wird mit einer Substrat-Transporteinheit 5 an das Positionierwerkzeug 1 und das Bilderkennungssystem 2 herangebracht.

Das Positionierwerkzeug 1 und das Bilderkennungssystem 2 verfügen über unabhängige, in der Figur nicht explizit dargestellte Antriebsachsen und Steuersysteme, welche jeweils eine Bewegung parallel zur Ebene des Substrates 4 erlauben. Für das Aufnehmen und Absetzen von Bauteilen 3 verfügt das Positionierwerkzeug 1 ausserdem über eine weitere Antriebsachse, welche eine Bewegung entlang der z-Richtung 12 erlaubt. Die lateralen Reichweiten des Positionierwerkzeugs 1 und des Bilderkennungssystems 2 sind jeweils durch die Ausdehnung der entsprechenden Antriebsachsen beschränkt und bestimmen den Arbeitsbereich 27 des Positioniersystems 200.

Das Steuersystem des Positionierwerkzeuges 1 erlaubt dessen Positionierung an Orten mit zugehörigen nominellen Werkzeugkoordinaten (X_{w}, Y_{w}). Entsprechend positioniert das Steuersystem des Bilderkennungssystems 2 das Bilderkennungssystem an Orte mit zugehörigen Kamerakoordinaten (X_{K}, Y_{K}).

Auf dem Substrat 4 sind eine oder mehrere Zielmarkierungen 6 angeordnet. Das Bilderkennungssystem 2 wird in x-Richtung 7 und in y-Richtung 8 über die Arbeitsfläche 23 bewegt, bis mindestens eine Zielmarkierung 6 im Bildbereich 9 des Bilderkennungssystems 2 liegt. Mit dem Bilderkennungssystem 2 werden die Koordinaten der Zielmarkierung 6 bestimmt und anschliessend das Positionierwerkzeug 1, ebenfalls über Antriebsachsen und entlang einer x-Richtung 10 und einer y-Richtung 11, zur der entsprechenden x-y Position geführt.

Das Positionierwerkzeug 1 ist mit einer Referenzmarke 14 versehen, die auf einem Träger 19 angebracht ist, der fest mit dem Positionierwerkzeug 1 verbunden ist.

Für das Aufnehmen bzw. Ablegen von Bauteilen kann das Positionierwerkzeug 1 mit Unterdruck bzw. Luft- oder Überdruck beaufschlagt werden. Darüberhinaus kann das Positionierwerkzeug 1 weitere Funktionalitäten für das Rotieren und Beheizen von Bauteilen 3 aufweisen.

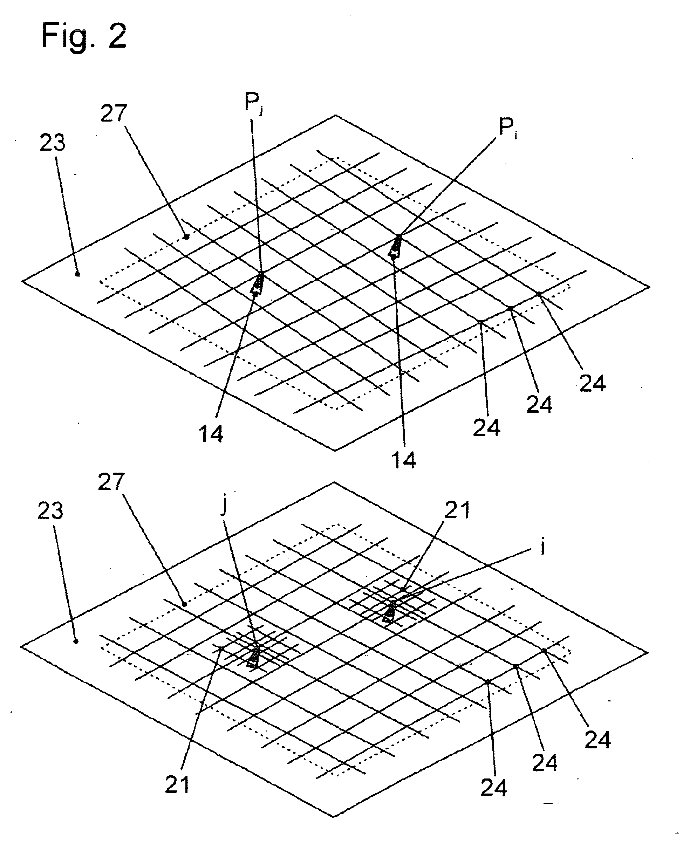

Figur 2 zeigt eine schematische Darstellung des Kalibrierverfahrens. Die beiden Teile der Darstellung zeigen jeweils einen dem Arbeitsbereich 27 des Positioniersystems entsprechenden Ausschnitt der Arbeitsfläche 23. Im oberen Teil der Darstellung sind schematisch Rasterpunkte 24 gezeigt, welche das Positionierwerkzeug im Kalibriermodus anfährt. Bezüglich der Arbeitsflache kann ein nominell regelmässiges und rechtwinkliges Raster durchaus Verzerrungen aufweisen, beispielsweise aufgrund von Nichtlinearitäten der Antriebsachsen des Positionierwerkzeuges.

Exemplarisch ist der Rasterpunkt Pᵢ hervorgehoben, an welchem das Positionierwerkzeug die Werkzeugkoordinaten (X_{wi}, Y_{wi}) hat. An einem weiteren exemplarischen Rasterpunkt Pⱼ hat das Positionierwerkzeug die Werkzeugkoordinaten (X_{wj}, Y_{wj}). Die Referenzmarke 14 hat jeweils bezüglich des Positionierwerkzeugs eine feste Position.

Im unteren Teil der Darstellung sind die entsprechenden Rasterpunkte 24, zu denen das Bilderkennungssystem jeweils nachgeführt wird, bezüglich der Arbeitsfläche 23 gezeigt. Am Rasterpunkt mit Buchstaben i hat das Bilderkennungssystem die Kamerakoordinaten (X_{Ki}, Y_{Ki}). Die Referenzmarke 14 wird vom Bilderkennungssystem abgebildet und hat im Bildkoordinatensystem 21 Bildkoordinaten (X_{Bi},Y_{Bi}). An jedem Rasterpunkt 24 werden die Werkzeugkoordinaten, die Kamerakoordinaten und die Bildkoordinaten des Referenzpunktes ermittelt, sodass eine Zuordnungstabelle von der folgenden Art entsteht.

| Rasterpunkt | Werkzeugkoordinaten | Kamerakoordinaten | Bildkoordinaten |
|---|---|---|---|
| 1 | (X_{W1}, Y_{W1}) | (X_{K1}, Y_{K1}) | (X_{B1}, Y_{B1}) |
| ... | ... | ... | ... |
| i | X_{Wi}, Y_{Wi}) | (X_{Ki}, Y_{Ki}) | (X_{Bi}, Y_{Bi}) |
| ... | ... | ... | ... |
| j | (X_{Wj}, Y_{Wj}) | (X_{Kj}, Y_{Kj}) | (X_{Bj}, Y_{Bj}) |
| ... | ... | ... | ... |

Die Lage der Referenzmarke 14 an einem Rasterpunkt i ist einerseits bezüglich der Arbeitsfläche 23 über die Kamerakoordinaten und Bildkoordinaten, andererseits bezüglich des Positionierwerkzeuges und seiner Werkzeugkoordinaten eindeutig festgelegt.

Entsprechend kann nach der Erfassung einer in der Figur nicht dargestellten Zielmarkierung auf der Arbeitsfläche 23 durch das Bildererkennungssystem über die entsprechenden Kamera- und Bildkoordinaten auf die Werkzeugkoordinaten des Positionierwerkzeuges geschlossen werden. Die Koordinaten können der Tabelle entweder direkt entnommen werden, oder sie können aus nahe liegenden Einträgen interpoliert werden.

Die Bildkoordinaten sind hierbei bereits als kalibriert vorausgesetzt, d.h. es wurde eine Zuordnung zwischen Punkten im Bildkoordinatensystem und entsprechenden tatsächlichen physikalischen Abmessungen in der Substratebene durchgeführt. Diese Kalibrierung hat vorweg in einem separaten Schritt zu erfolgen.

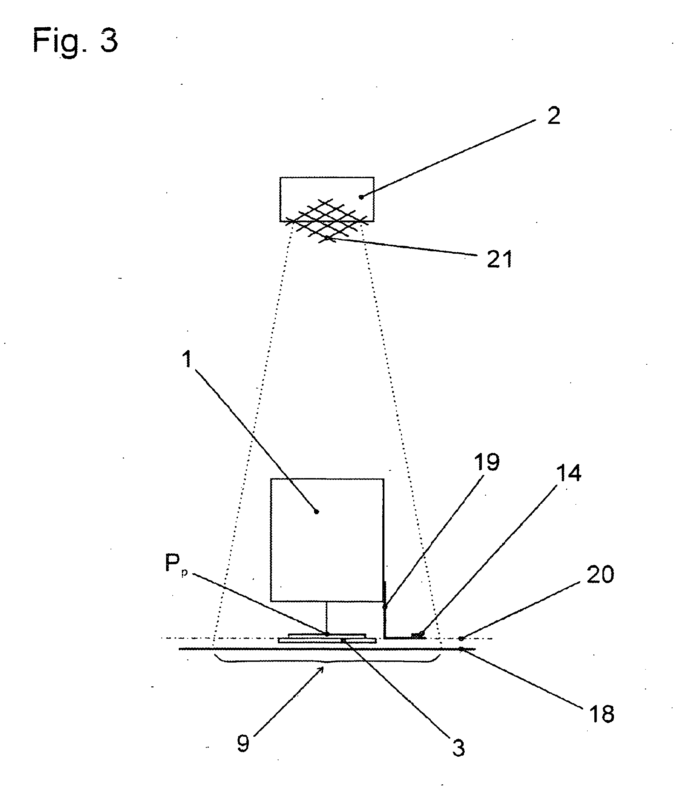

Figur 3 zeigt eine schematische Seitenansicht eines Positionierwerkzeugs 1. Das Positionierwerkzeug 1 ist mit einer Referenzmarke 14 versehen, die auf einem Träger 19 angebracht ist. Der Träger 19 ist so ausgelegt, dass die Referenzmarke 14 im Bildbereich 9 des Bilderkennungssystems 2 liegt, wenn sich dieses mittig über dem Positionierwerkzeug 1 befindet. Gleichzeitig ist die Referenzmarke 14 bezüglich des Positionierwerkzeugs 1 in einer Ebene 20 angeordnet, welche sich möglichst knapp oberhalb des vom Positionierwerkzeug transportierten Bauteils 3 befindet. Die Referenzmarke 14 lässt sich somit ohne Kollision mit bereits platzierten Bauteilen so nah wie möglich an die Substratebene 18 heranführen, auf welche das Bilderkennungssystem 2 zum Erfassen von Zielmarkierungen optimiert ist.

Die Referenzmarke 14 hat bezüglich dem Positionierwerkzeug 1, insbesondere zu einem Punkt P_{P} auf dem Positionierwerkzeug 1, den es bezüglich der in dieser Figur nicht gezeigten Zielmarkierung zu positionieren gilt, eine feste Lage. Die Position der Referenzmarke bezüglich des Bildkoordinatensystems 21 des Bilderkennungssystems 2 wird vom Bilderkennungssystem 2 bestimmt.

Kann das Bilderkennungssystem 2 nicht, wie in der Figur gezeigt, mittig über dem Positionierwerkzeug 1 angeordnet werden, um die Referenzmarke 14 zu erfassen, so muss der Versatz zwischen Bilderkennungssystem 2 und Positionierwerkzeug 1 bei der Kalibrierung berücksichtigt werden.

Befindet sich das Positionierwerkzeug 1 am Rand des Arbeitsbereiches, so kann die dann gegebenenfalls darüber hinausragende Referenzmarke 14 vom Bilderkennungssystem 2 nur dann erfasst werden, falls dessen Arbeitsbereich entsprechend grösser ist.

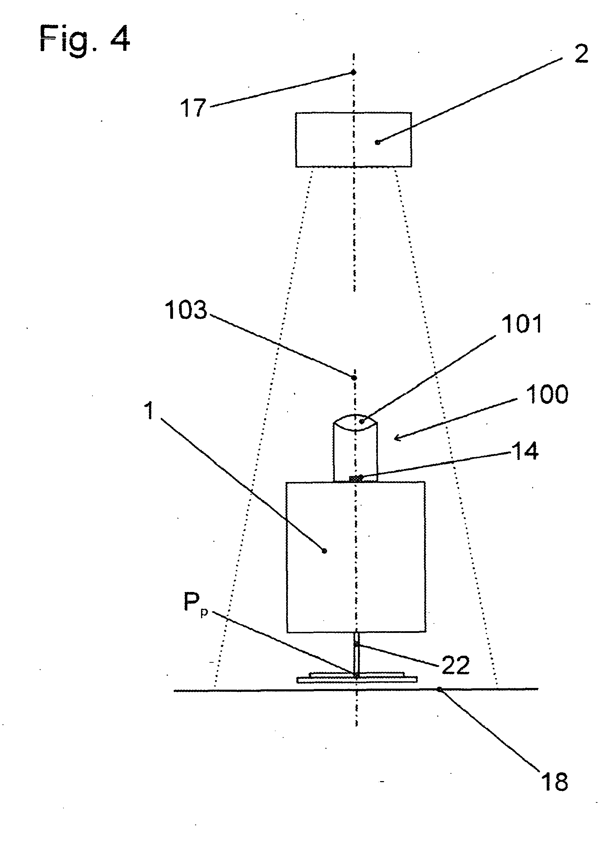

Ein Versatz zwischen Bilderkennungssystem 2 und Positionierwerkzeug 1 lässt sich allerdings vermeiden, wenn wie in Figur 4 anhand einer zweiten schematische Seitenansicht eines Positionierwerkzeuges 1 gezeigt ist, das Positionierwerkzeug 1 mit einer Kalibriervorrichtung 100 ausgestattet ist und die Referenzmarke 14 auf dem Positionierwerkzeug 1 angeordnet ist.

Die Kalibriervorrichtung 100 umfasst ein optisches System 101. Das optische System 101, hier aus einer Linse bestehend, modifiziert die Abbildung der Referenzmarke 14 durch das Bilderkennungssystem 2 derart, dass die Abbildung derjenigen einer Referenzmarke 14 entspricht, die in der Substratebene 18 angeordnet ist und ohne optisches System durch das Bilderkennungssystem 2 "scharf" abgebildet wird.

Bevorzugt befindet sich die Referenzmarke 14 auf der optischen Achse 103 des optischen Systems 101, die parallel zur optischen Achse 17 des Bilderkennungssystems 2 und durch einen zentralen Punkt P_{P} des Positionierwerkzeug 1 verläuft, insbesondere durch die Düse 22 des "Pick und Place"- Werkzeugs. In dem gezeigten, bevorzugten Fall verlaufen die optischen Achse 17, 103 senkrecht zur Substratebene 18. Ist das Bilderkennungssystem 2 mittig über dem Positionierwerkzeug 1 angeordnet, so liegt die Referenzmarke 14 auf der optischen Achse 17.

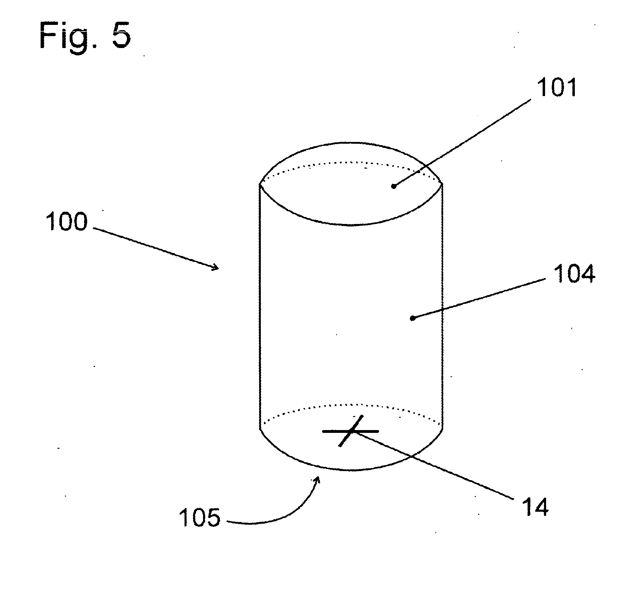

Figur 5 zeigt eine schematische Seitenansicht einer möglichen Ausführung einer Kalibriervorrichtung 100, wobei das optische System 101 monolithisch aufgebaut ist. Die Vorrichtung 100 besteht hier allein aus einem geeignet geformten Linsenkörper 104, an dessen ebener Unterseite 105 eine Referenzmarke 14, in diesem Fall in Form eines Kreuzes, angebracht ist. Die Referenzmarke 14 kann dem Linsenkörper 104 aufgemalt, aufgeklebt, eingeritzt oder eingeätzt sein.

Ein optisches Linsensystem zur Verwendung in einem Bilderkennungssystem weist besonders vorteilhaft die Merkmale im Anspruch 20 auf. Ersichtlicherweise könnte ein derartiges Linsensystem auch in anderen Bilderkennungssystemen eingesetzt werden, bei denen die Kamera sowohl eine Position in der Bilderkennungsebene, als auch eine Position auf einem zwischen der Bilderkennungsebene und der Kamera angeordneten Werkzeug erkennen muss. Je nach der auszugleichenden Differenz in der Schärfentiefe kann das Linsensystem unterschiedlich ausgebildet sein und möglicherweise auch mehrere Linsen aufweisen. Durch die Verwendung kurzbrennweitiger Linsen kann die Bauhöhe des optischen Linsensystems sehr klein gehalten werden.

## Patentansprüche

1. Verfahren zum Kalibrieren der x-y Positionierung eines Positionierwerkzeuges (1), das über einer Arbeitsfläche (23) positionierbar ist und dabei innerhalb eines Steuersystems des Positionierwerkzeugs (1) Werkzeugkoordinaten einnimmt, und das mit Hilfe eines Bilderkennungssystems (2) geführt wird, welches in einem Betriebsmodus zum Erfassen von Zielmarkierungen (6) auf der Arbeitsfläche (23) dient, **dadurch gekennzeichnet, dass** die x-y Positionierung des Positionierwerkzeuges bezüglich der Koordinaten des Bilderkennungssystems kalibriert wird, indem in einem Kalibriermodus
(i) das Positionierwerkzeug (1) auf einen Rasterpunkt (24) positioniert wird,
(ii) die Werkzeugkoordinaten des Rasterpunkts (24) erfasst werden,
(iii) eine in definierter Lage zum Positionierwerkzeug (1) angeordnete Referenzmarke (14) mit dem Bilderkennungssystems (2) erfasst wird,
(iv) die Koordinaten der Referenzmarke (14) bezüglich des Bilderkennungssystems (2) ermittelt werden,
(v) die Schritte (i)- (iv) an gleichen oder weiteren Rasterpunkten (24) wiederholt werden,
(vi) die Werkzeugkoordinaten und die Koordinaten im Bilderkennungssystem (2) der jeweiligen Rasterpunkte (24) mit einander in Bezug gesetzt und/oder abgeglichen werden;
und dass eine Nachschlagtabelle erstellt wird, mit welcher Werkzeugkoordinaten von Rasterpunkte (24) in Bezug zu den Kamerakoordinaten der Rasterpunkte (24) und/oder den Bildkoordinaten der Referenzmarke (14) an den jeweiligen Rasterpunkten (24) gestellt werden.

2. Verfahren gemäss Anspruch 1, **dadurch gekennzeichnet, dass** das Bilderkennungssystems unabhängig vom Positionierwerkzeug über der Arbeitsfläche positionierbar ist und dabei im Steuersystem des Bilderkennungssystems (2) Kamerakoordinaten einnimmt, das Bilderkennungssystems (2) nach Schritt (ii) an den Rasterpunkt nachgeführt wird, und die Koordinaten der Referenzmarke (14) im Bilderkennungssystem (2) mittels der Kamerakoordinaten und der Bildkoordinaten der Referenzmarke (14) festgestellt werden.

3. Verfahren gemäss Anspruch 1 oder 2, **dadurch gekennzeichnet, dass** die Rasterpunkte (24) beliebig auf der Arbeitsfläche konfigurierbar sind.

4. Verfahren gemäss einem der vorangehenden Ansprüche, **dadurch gekennzeichnet, dass** zumindest ein Teil der Koordinaten der Nachschlagtabelle mit linearer und/oder nicht-linearer Interpolation der erfassten Koordinaten an den Rasterpunkten (24) berechnet werden.

5. Verfahren gemäss mindestens einem der vorangehenden Ansprüche, **dadurch gekennzeichnet, dass** die Verfahrensschritte an einer vorbestimmten Abfolge von Rasterpunkten (24) ablaufen und/oder als ein erster Verfahrenschritt eine Auswahl von Rasterpunkten erfolgt.

6. Verfahren zum Kalibrieren eines Bilderkennungssystem basierten Positioniersystems, insbesondere mit einem "Pick and Place" - Werkzeug zum Platzieren eines Bauteils auf einem Substrat, **gekennzeichnet durch** die folgenden Verfahrensschritte,
(i) Kalibrierung der Bildkoordinaten des Bilderkennungssystems (2) bezüglich einer Referenzebene, insbesondere der Ebene (18) des Substrats,
(ii) Kalibrierung der x-y Positionierung des Positionierwerkzeuges (1) bezüglich des Bilderkennungssystems (2) gemäss einem der Ansprüche 1 bis 5.

7. Verfahren zum Platzieren eines Bauteils auf einem Substrat, mit einem Positionierwerkzeug, insbesondere einem "Pick und Place"-Werkzeug, und einem Bilderkennungssystem, **gekennzeichnet durch** die folgenden Verfahrensschritte,
(i) Kalibrierung der x-y Positionierung des Positionierwerkzeuges (1) bezüglich des Bilderkennungssystems (2) gemäss einem der Ansprüche 1 bis 6,
(ii) Erfassung einer auf dem Substrat angebrachten Zielmarkierung (6) mit dem Bilderkennungssystem (2) und Ermittlung der Koordinaten der Zielmarkierung (6) im Bilderkennungssystem (2),
(iii) Bestimmung der Werkzeugkoordinaten des Positionierwerkzeugs (1) aus den Koordinaten der Zielmarkierung (6) im Bilderkennungssystem (2) unter Verwendung der in (i) erfolgten Kalibrierung,
(iv) Positionierung des Positionierwerkzeugs (1),
(v) weiter mit (i) oder (ii).

8. Verfahren gemäss Anspruch 7, **dadurch gekennzeichnet, dass** bei der Kalibrierung der x-y Positionierung des Positionierwerkzeuges (1) bezüglich des Bilderkennungssystems (2) Werkzeugkoordinaten, Bildkoordinaten und Kamerakoordinaten an Rasterpunkten erhoben werden und die Bestimmung der Werkzeugkoordinaten des Positionierwerkzeugs (1) in Schritt (iii) aufgrund einer Interpolation zwischen den Koordinaten an den Rasterpunkten erfolgt.

9. Verfahren gemäss Anspruch 7 oder 8, **dadurch gekennzeichnet, dass** als erster Verfahrensschritt einer Kalibrierung der Bildkoordinaten des Bilderkennungssystems (2) bezüglich einer Referenzebene, insbesondere der Ebene (18) des Substrats, erfolgt.

10. Verfahren gemäss mindestens einem der Ansprüche 7 bis 9, **dadurch gekennzeichnet, dass** eine erneute Kalibrierung nach einem festen, einem konfigurierbaren oder einem adaptiven Zeitintervall oder nach einer festen, einer konfigurierbaren oder einer adaptiven Anzahl von Positionierungen stattfindet.

11. Verfahren zum Rekalibrieren bei dem Positionieren eines Bauteils auf einem Substrat mit einem Positionierwerkzeug, insbesondere einem "Pick und Place"-Werkzeug, und einem Bilderkennungssystem, **gekennzeichnet durch** die folgenden Verfahrensschritte,
(i) Erfassung einer auf dem Substrat angebrachten Zielmarkierung (6) mit dem Bilderkennungssystem (2) und Ermittlung der Koordinaten der Zielmarkierung (6) im Bilderkennungssystem (2),
(ii) Bestimmung der Werkzeugkoordinaten des Positionierwerkzeugs (1) aus den Koordinaten der Zielmarkierung (6) im Bilderkennungssystem (2),
(iii) Positionierung des Positionierwerkzeugs (1),
(iv) Erfassung einer in definierter Lage zum Positionierwerkzeug (1) angeordneten Referenzmarke (14) mit dem Bilderkennungssystem (2),
(v) Ermittlung der Koordinaten der Referenzmarke (14) bezüglich des Bilderkennungssystems (2),
(vi) Vergleich von ermittelten Koordinaten und zu erwartende Koordinaten der Referenzmarke (14) und/oder des Positionierwerkzeuges (1),
(vii) Festlegung einer Korrektur für eine nachfolgende Bestimmung der Werkzeugkoordinaten, falls bei dem Vergleich eine Abweichung festgestellt wird, die über einen vorgegebener Toleranzbereich hinausgeht.

12. Kalibriervorrichtung zum Kalibrieren der x-y Positionierung eines Bilderkennungssystem basierten Positionierwerkzeuges, insbesondere eines Pick und Place"- Werkzeuges zum Platzieren eines Bauteils auf einem Substrat, **dadurch gekennzeichnet, dass** die Kalibriervorrichtung (100) mindestens ein optisches System (101), insbesondere aus mindestens einer Linse bestehend, aufweist, und dass die Kalibriervorrichtung mit einer Referenzmarke (14), welche Referenzmarke (14) bezüglich des Positionierwerkzeuges mindestens eine definierte und/oder fixe Position besitzt, derart verbunden ist, dass die mindestens eine Referenzmarke (14) mit dem mindestens einen optischen System (101) derart durch das Bilderkennungssystem (2) abbildbar ist, dass die Abbildung derjenigen einer Referenzmarke entspricht, die in einer Referenzebene (20) in unmittelbarer Nähe zum Substrat liegt, und die ohne das optische System abgebildet wird.

13. Kalibriervorrichtung gemäss Anspruch 12, **dadurch gekennzeichnet, dass** das optische System (101) und die Referenzmarke (14) einen monolithischen Aufbau bilden.

14. Kalibriervorrichtung gemäss Anspruch 12 oder 13, **dadurch gekennzeichnet, dass** das optische System (101) mit dem Positionierwerkzeug (1) verbunden ist.

15. Kalibriervorrichtung gemäss mindestens einem der Ansprüche 12 bis 14, **dadurch gekennzeichnet, dass** die Referenzmarke (14) auf dem Positionierwerkzeug (1) angebracht ist.

16. Kalibriervorrichtung gemäss mindestens einem der Ansprüche 12 bis 15, **dadurch gekennzeichnet, dass** die Referenzmarke (14) auf einer Achse (103) angeordnet ist, die parallel zur optischen Achse (17) des Bilderkennungssystems (2) und durch einen zentralen Punkt P_{P} des Positionierwerkzeug verläuft, insbesondere durch die Düse (22) des "Pick und Place"- Werkzeugs (1) verläuft.

17. Kalibriervorrichtung gemäss mindestens einem der Ansprüche 12 bis 16, **dadurch gekennzeichnet, dass** die Abbildungseigenschaften des optischen Systems (101) verstellbar sind.

18. Kalibriervorrichtung gemäss mindestens einem der Ansprüche 12 bis 17, **dadurch gekennzeichnet, dass** die Referenzmarke (14) mit Mitteln zur Beleuchtung oder zum Leuchten versehen ist.

19. Kalibriervorrichtung gemäss mindestens einem der Ansprüche 12 bis 18, **dadurch gekennzeichnet, dass** die Referenzmarke (14) mindestens einen Punkt und/oder mindestens eine Ausrichtung kennzeichnet, insbesondere als Kreuz ausgebildet ist.

20. Optisches Linsensystem (101) zur Verwendung in einem Bilderkennungssystem (2), bei dem mittels einer Kamera über eine Bilderkennungsdistanz ein Bild in einer Bilderkennungsebene erkennbar ist, **dadurch gekennzeichnet, dass**
a. das optische Linsensystem (101) mit einer Referenzmarke (14) versehen ist, welche in der optischen Achse liegt,
b. das optische Linsensystem (101) derart mit einem Positionierwerkeug (1) zum Positionieren eines Bauteils auf einem Substrat verbunden oder verbindbar ist, dass die Referenzmarke (14) bezüglich des Positionierwerkzeuges (1) mindestens eine definierte und/oder fixe Position besitzt, und dass
c. das Linsensystem derart ausgebildet ist, dass eine Abweichung in der Schärfentiefe bei der Abbildung der Referenzmarke (14) entsprechend der Distanz zwischen Referenzmarke (14) und Bilderkennungsebene bezogen auf die Lage der Kamera korrigierbar ist, wobei die Bilderkennungsebene eine Substratebene eines Positioniersystems (200) ist, welches das Positionierwerkzeug (1) und das Bilderkennungssystem (2) umfasst.

## Claims

1. Method for calibrating the x-y-positioning of a place tool (1), which may be positioned above a work surface (13), thus taking up tool coordinates within a control system of the place tool (1), and which is guided by means of an image recognition system (2) which, in an operation mode, serves for capturing target markings (6) on work surface (23), **characterized in that** the x-y-positioning of the place tool is calibrated relative to the coordinates of the image recognition system, wherein, in a calibration mode,
(i) the place tool (1) is positioned over a grid point (24),
(ii) the tool coordinates of grid point (24) are registered,
(iii) a reference marking (14) located at a location defined in relation to the place tool (1) is captured by means of the image recognition system (2),
(iv) coordinates of the reference marking (14) relative to the image recognition system (2) are determined,
(v) steps (i) to (iv) are repeated at identical or further grid points (24), and
(vi) tool coordinates and coordinates in the image recognition system (2) of the respective grid points (24) are set into relation to and/or offset against one another,
and that a look-up table is generated, by means of which tool coordinates of grid points (24) are set in relation to camera coordinates of the grid points (24) and/or image coordinates of the reference marking (14) are set in relation to one another at the respective grid points (24).

2. The method according to claim 1, **characterized in that** the image recognition system may be positioned above the work surface independent of the place tool, thus taking up camera coordinates defined in the control system of the image recognition system (2), that after step (ii) the image recognition system (2) is tracked to the grid point, and that the coordinates of the reference marker (14) in the image recognition system (2) are determined by means of the camera coordinates and the image coordinates of the reference marker (14).

3. The method according to one of claims 1 or 2, **characterized in that** the grid points (24) may be configured arbitrarily on the work surface.

4. The method according to one of the previous claims, **characterized in that** at least a fraction of the coordinates in the look up table is computed by means of linear and/or non-linear interpolation of the coordinates registered at the grid points (24).

5. The method according to one of the previous claims, **characterized in that** the method steps are carried out with a predetermined order of grid points (24), and/or that a selection of grid points takes place as a first method step.

6. A method for calibrating a positioning system based on an image recognition system, in particular with a "pick-and-place"-tool for positioning a component on a substrate, **characterized by** the method steps of
(i) calibrating the image coordinates of the image recognition system (2) relative to a reference plane, in particular the plane (18) of the substrate,
(ii) calibrating the x-y positioning of the place tool (1) relative to the image recognition system (2) according to one of claims 1 to 5.

7. A method for placing a component onto a substrate by means of a place tool, in particular a "pick-and-place"-tool, and an image recognition system, **characterized by** method steps as follows:
(i) calibrating the x-y positioning of the place tool (1) relative to the image recognition system (2) according to one of claims 1 to 6.
(ii) capturing of a target marking (6) provided on the substrate by means of the image recognition system (2), and determining the coordinates of the target marking (6) in the image recognition system (2),
(iii) determining the tool coordinates of the place tool (1) from the coordinates of the target marking (6) in the image recognition system (2) using the calibration carried out in step (i),
(iv) positioning the place tool (1),
(v) continuing with step (i) or step (ii).

8. The method according to claim 7, **characterized in that** during calibration of the x-y positioning of the place tool (1) relative to the image recognition system (2) tool coordinates, image coordinates and camera coordinates are obtained at grid points, and the determination of the tool coordinates of the place tool (1) in step (iii) is carried out based on an interpolation between the coordinates at the grid points.

9. The method according to claim 7 or 8, **characterized in that** a calibration of the image coordinates of the image recognition system (2) relative to a reference plane, in particular the plane (18) of the substrate, is carried out a first method step.

10. The method according to one of claims 7 to 9, **characterized in that** a renewed calibration takes place after a fixed, a configurable or an adaptive time interval or after a fixed, a configurable or an adaptive number of positioning steps.

11. Method for recalibrating the positioning of a component on a substrate by means of a place tool, in particular a "pick-and-place"-tool, and an image recognition system, **characterized by** the following method steps:
(i) capturing of a target marking (6) provided on the substrate by means of the image recognition system (2), and determining the coordinates of the target marking (6) in the image recognition system (2),
(ii) determining tool coordinates from the coordinates of the target marking (6) in the image recognition system (2),
(iii) positioning the place tool (1),
(iv) capturing of a reference marking (14) located at a known location defined in relation to the place tool (1) by means of the image recognition system (2),
(v) determining the coordinates of the reference marking (14) relative to the image recognition system (2),
(vi) comparing of coordinates of the reference marking (14) and/or the place tool (1) as determined and as expected,
(vii) if a deviation which exceeds a predefined tolerance level is detected in the comparison, setting a correction for a subsequent determination of the tool coordinates.

12. Calibration device for calibrating the x-y-positioning of an image recognition system based place tool (1), in particular a "pick-and-place"-tool, for positioning a component on a substrate, **characterized in that** the calibration device (100) comprises at least one optical system (101), in particular consisting of at least one lens, and that the calibration device is connected with a reference marker (14), said reference marker (14) having a defined and/or fixed position relative to the place tool, in such a manner that the at least one reference marker (14) may be imaged by means of the at least one optical system (101) through the image recognition system such that the image corresponds to an image of a reference marker located in a reference plane (20), which is in immediate proximity to the substrate, and where said reference marker is imaged without the optical system.

13. The calibration device according to claim 12, **characterized in that** the optical system (101) and the reference marker (14) are of monolithic design.

14. The calibration device according to claim 12 or 13, **characterized in that** the optical system (101) is connected to the place tool (1).

15. The calibration device according to at least one of claims 12 to 14, **characterized in that** the reference marker (14) is attached to the place tool (1).

16. The calibration device according to at least one of claims 12 to 15, **characterized in that** the reference marker (14) is located on an axis (103) which extends parallel to the optical axis (17) of the image recognition system (2) and through a central point Pp of the place tool, in particular through the jet (22) of the "pick-and-place"-tool (1).

17. The calibration device according to at least one of claims 12 to 16, **characterized in that** the imaging properties of the optical system (101) are adjustable.

18. The calibration device according to at least one of claims 12 to 15, **characterized in that** the reference marker (14) is provided with means for illumination or for emitting light.

19. The calibration device according to at least one of claims 12 to 18, **characterized in that** the reference marker (14) features at least one point or alignment, in particular that the reference marker (14) is shaped as a cross.

20. Optical lens system (101) for use in an image recognition system (2), configured to make visible a figure lying in an image recognition plane by means of a camera, **characterized in that**
(i) the optical lens system is provided with a reference marker (14) located on the optical axis
(ii) the optical lens system is connected or connectable to a place tool (1) for placing a component on a substrate such that the reference marker (14) is located at a defined and/or fixed position relative to the place tool (1),
(iii) the lens system is configured to correct a deviation in depth of field in accordance with a distance between the reference marker (14) and the image recognition plane relative to the position of the camera, wherein the image recognition plane is a substrate plane of a positioning system (200), which positioning system (200) comprises the positioning tool (1) and the image recognition system (2).

## Revendications

1. Procédé pour le calibrage du positionnement x-y d'un outil de positionnement (1), qui peut être positionné au-dessus d'une surface de travail (23) et occupe alors des coordonnées d'outil à l'intérieur d'un système de commande de l'outil de positionnement (1), et qui est guidé à l'aide d'un système de reconnaissance d'image (2), lequel sert dans un mode de service à enregistrer des marquages cibles (6) sur la surface de travail (23), **caractérisé en ce que** le positionnement x-y de l'outil de positionnement est calibré par rapport aux coordonnés du système de reconnaissance d'image du fait que, dans un mode de calibrage,
(i) l'outil de positionnement (1) est positionné sur un point de trame (24),
(ii) les coordonnées d'outil du point de trame (24) sont enregistrées,
(iii) une marque de référence (14) disposée dans la position définie par rapport à l'outil de positionnement (1) est enregistrée avec le système de reconnaissance d'image (2),
(iv) les coordonnées de la marque de référence (14) par rapport au système de reconnaissance d'image (2) sont déterminées,
(v) les étapes (i) - (iv) sont répétées en des points de trame identiques ou d'autres points de trame (24),
(vi) les coordonnées d'outil et les coordonnées dans le système de reconnaissance d'image (2) des points de trame respectifs (24) sont mis en rapport les uns avec les autres et/ou harmonisés ;
et **en ce qu'**un tableau de référence est élaboré, avec lequel des coordonnées d'outil de points de trame (24) par rapport aux coordonnées de caméra des points de trame (24) et/ou aux coordonnées d'image de la marque de référence (14) sur les points de trame (24) respectifs sont fournies.

2. Procédé selon la revendication 1, **caractérisé en ce que** le système de reconnaissance d'image peut être positionné indépendamment de l'outil de positionnement au-dessus de la surface de travail et occupe alors des coordonnées de caméra dans le système de commande du système de reconnaissance d'image (2), le système de reconnaissance d'image (2) est asservi après l'étape (ii) au point de trame, et les coordonnées de la marque de référence (14) dans le système de reconnaissance d'image (2) sont déterminées au moyen des coordonnées de caméra et des coordonnées d'image de la marque de référence (14).

3. Procédé selon la revendication 1 ou 2, **caractérisé en ce que** les points de trame (24) peuvent être configurés de façon quelconque sur la surface de travail.

4. Procédé selon l'une des revendications précédentes, **caractérisé en ce qu'**au moins une partie des coordonnées du tableau de référence avec interpolation linéaire et/ou non linéaire des coordonnées enregistrées est calculée sur les points de trame (24).

5. Procédé selon au moins l'une des revendications précédentes, **caractérisé en ce que** les étapes de procédé se déroulent au moyen d'une succession prédéfinie de points de trame (24) et/ou un choix de points de trame s'effectue comme une première étape du procédé.

6. Procédé pour calibrer un système de positionnement basé sur le système de reconnaissance d'image, en particulier avec un outil "Pick und Place" pour le placement d'un composant sur un substrat, **caractérisé par** les étapes de procédé suivantes,
(i) calibrage des coordonnées d'image du système de reconnaissance d'image (2) par rapport à un plan de référence, en particulier le plan (18) du substrat,
(ii) calibrage du positionnement x-y de l'outil de positionnement (1) par rapport au système de reconnaissance d'image (2) selon l'une des revendications 1 à 5.

7. Procédé pour le placement d'un composant sur un substrat, avec un outil de positionnement, en particulier un outil "Pick und Place", et un système de reconnaissance d'image, **caractérisé par** les étapes de procédé suivantes,
(i) calibrage du positionnement x-y de l'outil de positionnement (1) par rapport au système de reconnaissance d'image (2) selon l'une des revendications 1 à 6,
(ii) enregistrement d'un marquage cible (6) placé sur le substrat avec le système de reconnaissance d'image (2) et calcul des coordonnées du marquage cible (6) dans le système de reconnaissance d'image (2),
(iii) détermination des coordonnées d'outil de l'outil de positionnement (1) à partir des coordonnées du marquage cible (6) dans le système de reconnaissance d'image (2) avec utilisation du calibrage effectué à l'étape (i),
(iv) positionnement de l'outil de positionnement (1),
(v) poursuivre avec (i) ou (ii).

8. Procédé selon la revendication 7, **caractérisé en ce que**, lors du calibrage du positionnement x-y de l'outil de positionnement (1) par rapport au système de reconnaissance d'image (2), les coordonnées d'outil, les coordonnées d'image et les coordonnes de caméra sont prélevées sur des points de trame et le calcul des coordonnées d'outil de l'outil de positionnement (1) s'effectue à l'étape (iii) sur la base d'une interpolation entre les coordonnées sur les points de trame.

9. Procédé selon la revendication 7 ou 8, **caractérisé en ce que**, comme première étape du procédé, on procède à un calibrage des coordonnées d'image du système de reconnaissance d'image (2) par rapport à un plan de référence, en particulier le plan (18) du substrat.

10. Procédé selon au moins l'une des revendications 7 à 9, **caractérisé en ce qu'**un calibrage renouvelé a lieu après un intervalle de temps fixe, un intervalle de temps configurable ou un intervalle de temps adaptatif ou après un nombre fixe, un nombre configurable ou un nombre adaptatif de positionnements.

11. Procédé pour le recalibrage lors du positionnement d'un composant sur un substrat avec un outil de positionnement, en particulier un outil "Pick und Place", et un système de reconnaissance d'image, **caractérisé par** les étapes de procédé suivantes,
(i) enregistrement d'un marquage cible (6) placé sur le substrat avec le système de reconnaissance d'image (2) et détermination des coordonnées du marquage cible (6) dans le système de reconnaissance d'image (2),
(ii) détermination des coordonnées d'outil de l'outil de positionnement (1) à partir des coordonnées du marquage cible (6) dans le système de reconnaissance d'image (2),
(iii) positionnement de l'outil de positionnement (1),
(iv) enregistrement d'une marque de référence (14) disposée dans une position définie par rapport à l'outil de positionnement (1) avec le système de reconnaissance d'image (2),
(v) détermination des coordonnées de la marque de référence (14) par rapport au système de reconnaissance d'image (2),
(vi) comparaison de coordonnées déterminées et des coordonnées à escompter ou de la marque de référence (14) et/ou de l'outil de positionnement (1),
(vii) définition d'une correction pour une détermination consécutive des coordonnées d'outil dans le cas où l'on constate lors de la comparaison un écart qui dépasse une plage de tolérance prédéfinie.

12. Dispositif de calibrage pour le calibrage du positionnement x-y d'un outil de positionnement basé sur le système de reconnaissance d'image, en particulier d'un outil "Pick und Place" pour le placement d'un composant sur un substrat, **caractérisé en ce que** le dispositif de calibrage (100) présente au moins un système optique (101), constitué en particulier d'au moins une lentille, et **en ce que** le dispositif de calibrage est relié à une marque de référence (14), laquelle marque de référence (14) présente par rapport à l'outil de positionnement au moins une position définie et/ou une position fixe, de telle sorte que la au moins une marque de référence (14) peut être reproduite avec le au moins un système optique (101) par le système de reconnaissance d'image (2) de telle sorte que la représentation correspond à celle d'une marque de référence qui se situe dans un plan de référence (20) à proximité immédiate du substrat, et qui est reproduite sans le système optique.

13. Dispositif de calibrage selon la revendication 12, **caractérisé en ce que** le système (101) optique et la marque de référence (14) forment une structure monolithique.

14. Dispositif de calibrage selon la revendication 12 ou 13, **caractérisé en ce que** le système (101) optique est relié à l'outil de positionnement (1).

15. Dispositif de calibrage selon au moins l'une des revendications 12 et 14, **caractérisé en ce que** la marque de référence (14) est placée sur l'outil de positionnement (1).

16. Dispositif de calibrage selon au moins l'une des revendications 12 à 15, **caractérisé en ce que** la marque de référence (14) est disposée sur un axe (103) qui est agencé parallèlement à l'axe (17) optique du système de reconnaissance d'image (2) et passe par un point central Pₚ de l'outil de positionnement, en particulier passe par la buse (22) de l'outil "Pick und Place" (1).

17. Dispositif de calibrage selon au moins l'une des revendications 12 à 16, **caractérisé en ce que** les propriétés de représentation du système (101) optique sont réglables.

18. Dispositif de calibrage selon au moins l'une des revendications 12 à 17, **caractérisé en ce que** la marque de référence (14) est dotée de moyens pour l'éclairage ou pour l'illumination.

19. Dispositif de calibrage selon au moins l'une des revendications 12 à 18, **caractérisé en ce que** la marque de référence (14) identifie au moins un point et/ou au moins une orientation, en particulier est conçue sous forme de croix.

20. Système de lentille (101) optique pour une utilisation dans un système de reconnaissance d'image (2), dans lequel une image peut être reconnue dans un plan de reconnaissance d'image au moyen d'une caméra par une distance de reconnaissance d'image, **caractérisé en ce que**
a. le système de lentille (101) optique est doté d'une marque de référence (14) qui se situe dans l'axe optique,
b. le système de lentille (101) optique est relié ou peut être relié à un outil de positionnement (1) pour le positionnement d'un composant sur un substrat, de telle sorte que la marque de référence (14) par rapport à l'outil de positionnement (1) présente au moins une position définie et/ou une position fixe, et **en ce que**
c. le système de lentille est conçu de telle sorte qu'un écart dans la profondeur de champ peut être corrigé lors de la représentation de la marque de référence (14) en fonction de la distance entre la marque de référence (14) et le plan de reconnaissance d'image par rapport à la position de la caméra, **en ce que** le plan de reconnaissance d'image est un plan de substrat d'un système de positionnement, qui comprend l'outil de positionnement (1) et le système de reconnaissance d'image (2).
